# EUROPÄISCHE PATENTSCHRIFT

(11) **EP 3 320 127 B1**
(45) Veröffentlichungstag und Bekanntmachung des Hinweises auf die Patenterteilung: **01.06.2022**
(21) Anmeldenummer: 16731546.4
(22) Anmeldetag: 14.06.2016
(51) Int. Cl.: C23C 28/00, C23C 14/14, C23C 14/16, C23C 14/34, F01D 5/28

(54) **KONTURTREUE SCHUTZSCHICHT FÜR VERDICHTERBAUTEILE VON GASTURBINEN**
CONTOUR-FOLLOWING PROTECTIVE COATING FOR COMPRESSOR COMPONENTS OF GAS TURBINES
COUCHE PROTECTRICE À CONTOURNAGE PRÉCIS POUR ÉLÉMENTS STRUCTURAUX DE COMPRESSEUR POUR DES TURBINES À GAZ

(30) Priorität: 06.07.2015 DE 102015212588
(43) Veröffentlichungstag der Anmeldung: 16.05.2018
(73) Patentinhaber: Siemens Aktiengesellschaft, 80333 München (DE); Oerlikon Surface Solutions AG, Pfäffikon, 8808 Pfäffikon (CH)
(72) Erfinder: ANNEN, Michael, 47259 Duisburg (DE); BARNIKEL, Jochen, 45470 Mülheim an der Ruhr (DE); FLORES RENTERIA, Arturo, 12161 Berlin (DE); GHICOV, Andrei, 91058 Erlangen (DE); HESSEL, Sascha, 55442 Warmsroth (DE); NEDDEMEYER, Torsten, 14612 Falkensee (DE); RAMM, Jürgen, 7304 Maienfeld (CH)
(86) Internationale Anmeldenummer: PCT/EP2016/063557
(87) Internationale Veröffentlichungsnummer: WO 2017/005460

(56) Entgegenhaltungen:
- EP-A1- 2 754 733
- WO-A1-2010/012701
- WO-A1-2010/094256
- DE-A1-102010 028 558

## Beschreibung

Die vorliegende Erfindung betrifft ein Gasturbinenbauteil mit einem korrosiv beanspruchten Substrat und einem Beschichtungssystem sowie ein Verfahren zum Herstellen eines Beschichtungssystems.

Bauteile von Gasturbinen sind einem Korrosionsmedium ausgesetzt. Zum Schutz dieser Bauteile vor Korrosion werden Beschichtungen aufgebracht. So wird für Verdichterbauteile von Gasturbinen, besonders von stationären Gasturbinen, ein Aluminiumpartikel-haltiger Hochtemperaturlack eingesetzt. Beschichtungen dieser Art weisen jedoch eine geringe Integralhärte auf (ca. 50 HV). Dadurch ist auch die Erosionsbeständigkeit (z.B. gegen Partikelerosion oder Tropfenschlagerosion) relativ niedrig. Die geringe Integralhärte ist vor allem auf die weichen Aluminium-Partikel in der Beschichtung zurückzuführen. Die Bauteile müssen wegen der niedrigen Erosionsbeständigkeit nach bestimmten Zeitintervallen auf Erosion untersucht und, falls erforderlich, entschichtet, geprüft und mit der gleichen Beschichtung neubeschichtet werden. Dieses Vorgehen ist zeitaufwändig und arbeitsintensiv.

Aus der WO 2010/094256 A1 ist ein Gasturbinenbauteil aus einem Grundwerkstoff mit einem darauf vorgesehenen Erosionsschutz-Beschichtungssystem, welches ein Mehrschichtsystem aus einer duktilen, metallischen Schicht und einer harten, keramikhaltigen Schicht zur Bildung eines Erosionsteilschutzsystems umfasst, bekannt. Zwischen Erosionsteilschutzsystem und dem Grundwerkstoff ist eine Korrosionsschutzschicht vorgesehen, die gegenüber dem zu beschichtenden Grundwerkstoff ein niedrigeres elektrochemisches Potenzial als der Grundwerkstoff aufweist, so dass ein kathodischer Korrosionsschutz ausgebildet ist.

Die DE 10 2010028 558 A1 ist ein Verfahren zum Abscheiden von Mischkristallschichten mit wenigstens zwei verschiedenen Metallen auf einem Substrat mittels PVD-Verfahren bekannt. Um ein Verfahren zum Abscheiden von Mischkristallschichten mit wenigstens zwei verschiedenen Metallen auf einem Substrat mittels PVD-Verfahren bereitzustellen, mit dem man Mischkristallschichten erhält, die möglichst frei sind von Makropartikeln und die einen möglichst hohen Anteil einer gewünschten kristallinen Phase aufweisen und hochkristallin sind, wird vorgeschlagen, dass das Abscheiden der Mischkristallschicht unter gleichzeitiger Anwendung von Kathodenzerstäubung und Lichtbogenverdampfen durchgeführt wird.

Es besteht darum die Aufgabe, die Erosionsbeständigkeit von Bauteilen von Gasturbinen zu verbessern.

Diese Aufgabe wird durch ein Gasturbinenbauteil mit den Merkmalen gemäß Anspruch 1 gelöst. Weitere vorteilhafte Ausführungsformen der Erfindung ergeben sich aus den Neben- und Unteransprüchen, den Figuren und den Ausführungsbeispielen.

Ein erster Aspekt der Erfindung betrifft ein Gasturbinenbauteil mit einem korrosiv beanspruchten Substrat und einem Beschichtungssystem, mindestens umfassend eine erste, zweite und dritte Schicht, bei der
- die zwischen einer Oberfläche des Substrats und der zweiten Schicht angeordnete erste Schicht als Haftvermittlerschicht ausgebildet ist,
- die zweite Schicht eine duktile metallische Schicht mit einer Kolumnarstruktur ist, und
- die auf der vom Substrat weggewandten Seite der zweiten Schicht angeordnete dritte Schicht eine keramische Oxidschicht mit einer Härte von mindestens 20 GPa ist.

Das erfindungsgemäße Gasturbinenbauteil ist vorteilhaft, weil es verglichen mit herkömmlichen Gasturbinenbauteilen weniger wartungsanfällig ist und die Wartungs- und Reparaturintervalle großzügiger gewählt werden können. Dadurch ist das Gasturbinenbauteil ökonomisch effektiver, da weniger Kosten und weniger Zeit für seine Wartung aufgewendet werden müssen. Neben einer erhöhten Erosionsbeständigkeit weist das Beschichtungssystem des erfindungsgemäßen Gasturbinenbauteils mindestens ähnliche Schwingungsrisskorrosionseigenschaften auf wie ein Aluminiumpartikel-haltiger Hochtemperaturlack.

Die Härteangabe in der Einheit GPa bezieht sich auf den Druck, den die Beschichtung dem Eindringen eines Gegenstands entgegensetzen kann.

Die Ausbildung der ersten Schicht als Haftvermittlerschicht sorgt für eine höhere Haftung zwischen Grundwerkstoff und der zweiten Schicht des Beschichtungssystems. Bevorzugt weist die erste Schicht des Beschichtungssystems Chrom oder Chromnitrid auf.

Die zweite Schicht schützt das Substrat vorteilhaft kathodisch durch seine Funktion als Opferanode. Die Duktilität der zweiten Schicht dient vorteilhaft zum Abfangen von Dehnungen bei schwingender Belastung, ohne dass Risse in der Schicht auftreten. Die Kolumnarstruktur der zweiten Schicht dient vorteilhaft zum Ausgleich von Eigenspannungen, die durch die dritte Schicht verursacht werden. Bevorzugt besteht die Kolumnarstruktur der zweiten Schicht aus einer Aluminium-haltigen Legierung, z.B. einer Legierung umfassend Aluminium und Chrom.

Die dritte Schicht des erfindungsgemäßen Beschichtungssystems weist vorzugsweise Aluminiumoxid und / oder Chromoxid und / oder ein Aluminium-Chrom-Oxid in Mischkristallstruktur auf. Sie kann auch vollständig aus diesen Oxiden bestehen. Durch die Oxide ist die dritte Schicht beständig gegen Oxidation, da sie bereits aus mindestens einem Oxid besteht und damit bei hohen Temperaturen eingesetzt werden kann. Die dritte Schicht hat eine sehr dichte Struktur. Die dritte Schicht wirkt u.a. vorteilhaft als Korrosionsschutz für die zweite Schicht. Weiterhin wirkt die dritte Schicht auf Grund ihrer keramischen Beschaffenheit isolierend, wodurch vorteilhaft galvanische Effekte unterbunden werden. Weiterhin ist die dritte Schicht wesentlich härter als der Grundwerkstoff und wirkt deshalb für die darunter liegenden Lagen und den Grundwerkstoff vorteilhaft als Schutz gegen Erosion, besonders gegen Tropfenschlag- und Partikelerosion. Vorzugsweise beträgt die Härte der dritten Schicht etwa 25 GPa.

Bevorzugt ist das Substrat, auf dem die drei Schichten aufgetragen werden, ein Bestandteil eines Verdichterbauteils einer Gasturbine. Besonders bevorzugt ist das Substrat ein Bestandteil eines Verdichterbauteils einer stationären Gasturbine. Das Verdichterbauteil kann z.B. eine Verdichterschaufel sein.

Ein zweiter Aspekt der Erfindung betrifft ein Verfahren zum Herstellen eines Beschichtungssystems für ein Gasturbinenbauteil mit einem korrosiv beanspruchten Substrat, umfassend drei Schichten entsprechend des erfindungsgemäßen Gasturbinenbauteils, wobei das Material aller Schichten durch physikalische Gasphasenabscheidung (*physical vapour deposition*, PVD) aufgetragen wird. Das Verfahren ist vorteilhaft, weil eine Wärmebehandlung, die beim Auftragen herkömmlicher Schichten durchgeführt werden muss, nicht erforderlich ist. Weiterhin weisen durch PVD aufgetragene Schichten eine vorteilhafte Oberflächenrauigkeit auf, die gute aerodynamische Eigenschaften bewirkt. Weiterhin ist das PVD Verfahren zum Beschichten vorteilhaft, weil die Dicke der Schicht bis zu 10 µm betragen kann und somit beschichtete Bauteile konturgetreu nachgebildet werden können, d.h. keine zusätzlichen Maskierungen notwendig sind.

Vorzugsweise werden die Schichten des Beschichtungssystems durch kathodische Funkenverdampfung und / oder durch Sputtern aufgetragen. Mit anderen Worten können die Schichten durch eines der genannten Verfahren oder durch eine Kombination beider Verfahren aufgetragen werden.

Die Erfindung wird anhand der Figuren näher erläutert. Es zeigen
- Figur 1: eine Ausführungsform eines Beschichtungssystems.
- Figur 2: ein elektronenmikroskopisches Bild der Ausführungsform gemäß Figur 1.
- Figur 3: ein Fließdiagramm einer Ausführungsform des erfindungsgemäßen Verfahrens.

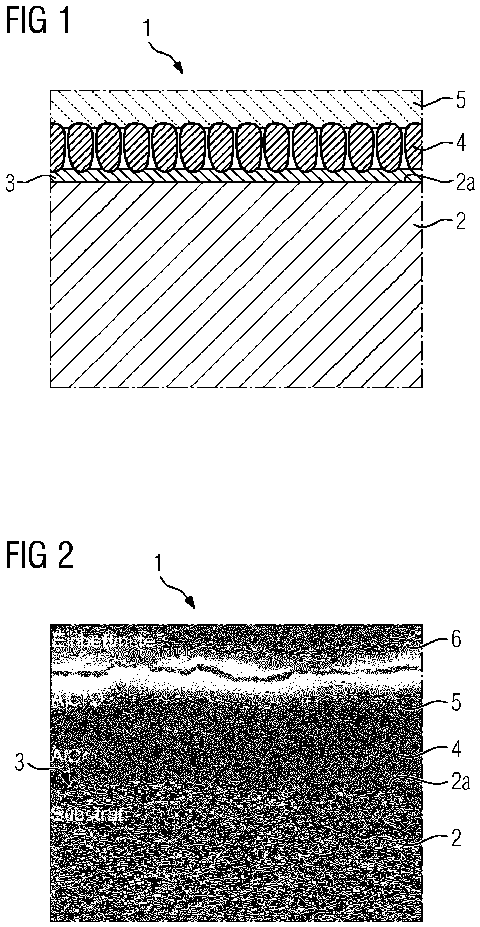

In der in Fig. 1 dargestellten Ausführungsform weist das Beschichtungssystem 1 ein Substrat 2 mit einer Oberfläche 2a, einer ersten Schicht 3, einer zweiten Schicht 4 und einer dritten Schicht 5 auf. Das Substrat 2 weist mindestens ein Metall auf und kann eine Metalllegierung sein. Unter korrosiven Bedingungen kann das Substrat 2 anfällig für Korrosion sein.

Die erste Schicht 3 ist auf der Oberfläche 2a angeordnet und weist eine Dicke von etwa 100 nm auf. Sie besteht bevorzugt aus Chrom oder Chromnitrid, kann in ihrer Eigenschaft als Haftvermittlerschicht aber auch andere Metalle bzw. eine andere Zusammensetzung aufweisen, z.B. vom Typ MCrAlY.

Die zweite Schicht 4 ist auf der ersten Schicht 3 angeordnet und weist eine Dicke im Bereich von 0,5 - 5,0 µm, bevorzugt von 1,0 - 3,0 µm auf. Die zweite Schicht 4 ist eine duktile metallische Schicht mit einer Kolumnarstruktur aus einer Aluminiumlegierung. Beispielhaft besteht die zweite Schicht 4 aus einer Aluminium und Chrom aufweisenden Legierung; alternativ kann die Legierung aber auch weitere oder andere Metalle als Chrom enthalten.

Die dritte Schicht 5 ist auf der zweiten Schicht 4 angeordnet und weist eine Dicke im Bereich von 0,5 - 10,0 µm, bevorzugt von 1,0 - 5,0 µm auf. Die dritte Schicht 5 ist eine harte keramische Oxidschicht mit einer sehr dichten Struktur. Das Material der dritten Schicht 5 ist eine Mischung aus Chrom- und Aluminiumoxid, bevorzugt aus einer Mischkristallverbindung aus Aluminium-Chrom-Oxid und zusätzlichen Al-Cr-intermetallischen Verbindungen. Es können auch weitere Oxide und andere Verbindungen oder Elemente in der dritten Schicht 5 vorhanden sein. Die dritte Lage 5 ist beständig gegen Korrosion, da sie bereits aus Oxiden besteht. Dadurch schützt die dritte Schicht 5 das Substrat 2 und die anderen Schichten gegen Korrosion. Die keramischen Bestandteile verleihen der dritten Schicht 5 eine große Härte, die typischerweise bei bis zu 25 GPa liegt. Die dritte Schicht 5 ist damit wesentlich härter als das Substrat 2 und die anderen Schichten. Die große Härte wird effektiv gegen Erosion, besonders gegen Tropfenschlag- und Partikelerosion.

Die Dicke des Beschichtungssystems kann insgesamt bis zu 20 µm betragen. Dabei können die einzelnen Schichten, besonders die zweite 4 und die dritte Schicht 5, auch eine höhere Dicke aufweisen als oben angegeben. Die in Fig. 2 gezeigte Einbettmasse 6 ist für metallographische Untersuchungen auf der dritten Schicht 5 aufgetragen. Die Einbettschicht weist anorganische Oxide auf. Figur 2 ist eine Abbildung einer rasterelektronenmikroskopischen Aufnahme eines Beschichtungssystems 1, in der die erste Schicht 3 wegen ihrer geringen Dicke kaum wahrnehmbar ist.

Das Substrat 2 gehört zu einem Verdichterbauteil, bevorzugt zu einer Verdichterschaufel einer stationären Gasturbine. Es kann jedoch auch zu einem anderen Bauteil bzw. Komponente einer stationären Gasturbine oder einer anderen Gasturbine gehören.

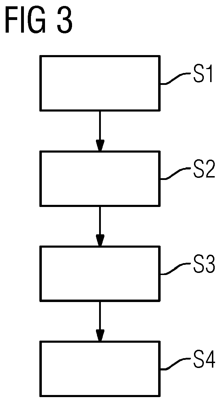

Zum Herstellen des beschriebenen Beschichtungssystems 1 wird in einer Ausführungsform des Verfahrens gemäß der Darstellung von Fig. 3 in einem ersten Schritt S1 ein Substrat 2 mit einer Oberfläche 2a bereitgestellt. In einem zweiten Schritt S2 wird das Material der ersten Schicht 3 durch physikalische Gasphasenabscheidung (*physical vapor deposition*, PVD) aufgetragen. In einem dritten Schritt S3 wird das Material der zweiten Schicht 4 ebenfalls durch PVD aufgetragen. In einem vierten Schritt S4 wird das Material der dritten Schicht 5 ebenfalls durch PVD aufgetragen.

Dabei wird als bevorzugte Methode der PVD eine kathodische Funkenverdampfung durchgeführt. Eine ebenfalls bevorzugte Methode ist Sputtern. Es ist ebenfalls bevorzugt, wenn die beiden Methoden miteinander kombiniert werden. Weitere mögliche anwendbare Methoden, die alternativ und / oder in Kombination mit den oben genannten Methoden verwendet werden können, sind thermisches Verdampfen, Elektronenstrahlverdampfen, Laserstrahlverdampfen oder Lichtbogenverdampfen.

Für einen Fachmann naheliegenden Abwandlungen und Änderungen der Erfindung fallen unter den Schutzumfang der Patentansprüche.

## Patentansprüche

1. Gasturbinenbauteil mit einem korrosiv beanspruchten Substrat (2) und einem Beschichtungssystem (1)), mindestens umfassend eine erste (3), zweite (4) und dritte Schicht (5), bei dem
- die zwischen einer Oberfläche (2a) des Substrats (2) und der zweiten Schicht (4) angeordnete erste Schicht (3) als Haftvermittlerschicht ausgebildet ist,
- die zweite Schicht (4) eine duktile metallische Schicht mit einer Kolumnarstruktur ist, und
- die auf der vom Substrat (2) weggewandten Seite der zweiten Schicht angeordnete dritte Schicht (5) eine keramische Oxidschicht mit einer Härte von mindestens 20 GPa ist.

2. Gasturbinenbauteil nach Anspruch 1,
bei dem die erste Schicht (3) Chrom oder Chromnitrid aufweist.

3. Gasturbinenbauteil nach Anspruch 1 oder 2,
bei dem die Kolumnarstruktur der zweiten Schicht (4) aus einer Aluminium-haltigen Legierung besteht.

4. Gasturbinenbauteil nach einem der vorherigen Ansprüche,
bei dem die dritte Schicht (5) Aluminiumoxid und/oder Chromoxid und / oder ein Aluminium-Chrom-Oxid in Mischkristallstruktur aufweist.

5. Gasturbinenbauteil nach einem der vorherigen Ansprüche,
bei dem die Härte der dritten Schicht (5) etwa 25 GPa beträgt.

6. Gasturbinenbauteil nach einem der vorherigen Ansprüche,
bei dem das Substrat (2) ein Bestandteil eines Verdichterbauteils einer Gasturbine ist.

7. Gasturbinenbauteil nach Anspruch 6,
bei dem das Substrat (2) Bestandteil eines Verdichterbauteils einer stationären Gasturbine ist.

8. Verfahren zum Herstellen eines Beschichtungssystems (1) für ein Gasturbinenbauteil mit einem korrosiv beanspruchten Substrat (2) gemäß einem der Ansprüche 1 bis 7, wobei das Material aller Schichten (3, 4, 5) durch physikalische Gasphasenabscheidung aufgetragen wird.

9. Verfahren nach Anspruch 8,
wobei das Material der Schichten (3, 4, 5) durch kathodische Funkenverdampfung und / oder durch Sputtern aufgetragen wird.

## Claims

1. Gas turbine component comprising a corrosively loaded substrate (2) and a coating system (1), at least comprising a first layer (3), a second layer (4) and a third layer (5), in which
- the first layer (3), which is arranged between a surface (2a) of the substrate (2) and the second layer (4), is in the form of an adhesion promoter layer,
- the second layer (4) is a ductile metallic layer having a columnar structure, and
- the third layer (5), which is arranged on that side of the second layer which faces away from the substrate (2), is a ceramic oxide layer having a hardness of at least 20 GPa.

2. Gas turbine component according to Claim 1,
in which the first layer (3) comprises chromium or chromium nitride.

3. Gas turbine component according to Claim 1 or 2,
in which the columnar structure of the second layer (4) consists of an aluminium-containing alloy.

4. Gas turbine component according to one of the preceding claims,
in which the third layer (5) comprises aluminium oxide and/or chromium oxide and/or an aluminium/chromium oxide in a solid solution structure.

5. Gas turbine component according to one of the preceding claims,
in which the hardness of the third layer (5) is approximately 25 GPa.

6. Gas turbine component according to one of the preceding claims,
in which the substrate (2) is a constituent part of a compressor component of a gas turbine.

7. Gas turbine component according to Claim 6,
in which the substrate (2) is a constituent part of a compressor component of a stationary gas turbine.

8. Method for producing a coating system (1) for a gas turbine component comprising a corrosively loaded substrate (2) according to one of Claims 1 to 7, wherein the material of all of the layers (3, 4, 5) is applied by physical vapour deposition.

9. Method according to Claim 8,
wherein the material of the layers (3, 4, 5) is applied by cathodic arc evaporation and/or by sputtering.

## Revendications

1. Pièce de turbine à gaz ayant un substrat (2) sollicité à la corrosion et un système (1) stratifié, comprenant au moins une première (3), deuxième (4) et troisième couche (5), dans lequel
- la première couche (3) disposée entre une surface (2a) de substrat (2) et la deuxième couche (4) est constituée comme couche d'agent adhésif,
- la deuxième couche (4) est une couche métallique ductile ayant une structure en colonne, et
- la troisième couche (5) disposée sur la face, loin du substrat (2), de la deuxième couche est une couche d'oxyde céramique d'une dureté d'au moins 20 GPa.

2. Pièce de turbine à gaz suivant la revendication 1,
dans laquelle la première couche (3) a du chrome ou du nitrure de chrome.

3. Pièce de turbine à gaz suivant la revendication 1 ou 2,
dans laquelle la structure en colonne de la deuxième couche (4) est en un alliage contenant de l'aluminium.

4. Pièce de turbine à gaz suivant l'une quelconque des revendications précédentes,
dans laquelle la troisième couche (5) a de l'oxyde d'aluminium et/ou de l'oxyde de chrome et/ou un oxyde d'aluminium et de chrome en une structure de solution solide.

5. Pièce de turbine à gaz suivant l'une des revendications précédentes,
dans laquelle la dureté de la deuxième couche (5) est d'environ 25 GPa.

6. Pièce de turbine à gaz suivant l'une des revendications précédentes,
dans laquelle le substrat (2) est une partie constitutive d'une pièce de compresseur d'une turbine à gaz.

7. Pièce de turbine à gaz suivant la revendication 6,
dans laquelle le substrat (2) est une partie constitutive d'une pièce de compresseur d'une turbine à gaz fixe.

8. Procédé de production d'un système (1) stratifié pour une pièce de turbine à gaz ayant un substrat (2) sollicité à la corrosion suivant l'une des revendications 1 à 7, dans lequel on dépose le matériau de toutes les couches (3, 4, 5) par dépôt physique en phase gazeuse.

9. Procédé suivant la revendication 8,
dans lequel on dépose le matériau des couches (3, 4, 5) par évaporation par étincelle et/ou par pulvérisation cathodique.
